# EUROPÄISCHE PATENTANMELDUNG

(11) **EP 1 394 290 A2**
(43) Veröffentlichungstag der Anmeldung: **03.03.2004**
(21) Anmeldenummer: 03017718.2
(22) Anmeldetag: 02.08.2003
(51) Int. Cl.: C25D 1/02, C23C 18/16, C25D 1/20, C23C 2/38, C23C 14/00, C23C 16/01

(54) **Verfahren zum Herstellen dünner Präzisionsrohre**

(30) Priorität: 28.08.2002 DE 10240221
(71) Anmelder: G. Rau GmbH. & Co.KG, 75172 Pforzheim (DE)
(72) Erfinder: Sedlmayr, Gerhard, 75331 Engelsbrand-Grunbach (DE); Ulmer, Jochen Dr., 70619 Stuttgart (DE); Nusskern, Hans, 75181 Pforzheim-Huchenfeld (DE)
(74) Vertreter: Jany, Peter, Dr.

(57) **Zusammenfassung**

Zum Herstellen einer Hohlform (2), insbesondere eines sehr dünnen Präzisionsrohres, wird vorgeschlagen, einen Kern (1), der vorzugsweise aus einer Formgedächtnislegierung besteht, mit einem Abscheideverfahren wie beispielsweise einem elektrolytischen Verfahren mit einem Werkstoff zu beschichten und nach dem Abkühlen den geschrumpften Kern (1) zu entformen, vorzugsweise ohne ihn zu recken.

## Beschreibung

Die Erfindung betrifft ein Verfahren zum Herstellen einer Hohlform, insbesondere eines Hohlprofils, mit kleinem Außendurchmesser und/oder kleiner Wandstärke aus Metall oder einem anderen Werkstoff. Derartige Bauteile, Hohlformen und Präzisionsrohre, beispielsweise mit Durchmesserbereichen von kleiner 0,1 mm, werden in verschiedenen technischen Gebieten benötigt, beispielsweise in der Meßund Regeltechnik, der Medizintechnik, der Kommunikationstechnik und der Mikrotechnik.

Üblicherweise erfolgt die Herstellung von metallischen Hohlprofilen und Bauteilen mit Hohlräumen, also von Hohlformen über das Schmelzen eines Barrens gefolgt von einer Vielzahl von Umformprozeßschritten wie Schmieden, Lochen, Pilgern oder Strangpressen, Hämmern und mehrfaches Ziehen mit Zwischenglühen. Diese Verfahren sind in Bezug auf den Anlagen-, Werkzeug- und Zeitbedarf sehr aufwendig.

Ferner sind Verfahren bekannt, bei denen in einem ersten Schritt ein massiver Kern mit dem Werkstoff der Hohlform beschichtet wird, wobei ein die Hohlform und den Kern umfassender Verbundblock gebildet wird, und in einem zweiten Schritt der Kern aus der Hohlform herausgelöst wird. Bei diesen Verfahren werden zur Erzeugung von Hohlformen Schichten auf einen Kern aufgebracht, der über verschiedene Methoden, beispielsweise Ausschmelzen, Aufweiten, thermisches Ausdehnen oder chemisches Lösen in einem Entformungsschritt aus dem Verbundblock entfernt werden.

Beispielsweise wurden galvanoplastische Verfahren zum Herstellen eines Rohres oder einer Hohlform in folgenden Dokumenten beschrieben. Das Dokument US 3,947,348 offenbart das Lösen eines metallischen Kerns durch unterschiedliche thermische Ausdehnungskoeffizienten. Das Dokument DE 3734769 A1 bezieht sich auf das Lösen eines leitfähig gemachten keramischen Kerns durch unterschiedliche thermische Ausdehnungskoeffizienten. Das Dokument US 4,276,148 beschreibt das Lösen eines Kerns durch Aufblasen des Kerns vor dem Abscheiden der Hohlform und nachfolgendes Auslassen des Füllmediums. Die Dokumente US 4,428,801 und US 4,326,928 offenbaren das Lösen des Kerns durch thermisches Schrumpfen und das Dokument US 5,693,210 das Lösen des Kerns durch Herausätzen.

Gemäß den Dokumenten US 4,651,174, EP 0 193 678 A1 und JP 2002080991 wird der Kern durch Abziehen der Hohlform mechanisch gelöst. Gemäß dem Dokument US 5,772,864 wird der Kern durch Auflösen entfernt und das Dokument US 4,681,864 schlägt vor, den Kern durch Ätzen herauszulösen.

Das Dokument DE 2132664 schlägt vor, den Kern durch Phasenumwandlung einer Fe-Ni-Legierung und Abschrecken des Verbundblocks zu entfernen. Gemäß dem Dokument DE 2947247 A1 wird der Kern durch thermisches Schrumpfen eines Kunststoffkerns entfernt und das Dokument DE 2645427 A1 beschreibt das Lösen eines Kerns durch Überziehen des Kerns mit einem leitfähig gemachten Kunststoffschlauch, der nach der Abscheidung des Materials der Hohlform thermisch geschrumpft wird.

Die Herstellung einer geschlossenen Hohlform, z.B. eines Wärmetauschers, mit Hilfe der Galvanoplastik durch Lösen des Kerns aufgrund einer mechanischen Querschnittsreduktion von Kunststoffkernen ist in dem Dokument DE 3522958 offenbart.

Die Herstellung eines Rohres oder einer Hohlform mit Hilfe der sogenannten Manteldrahttechnik ist in den Dokumenten US 5,013,507 und US 5,709,021 offenbart. Dabei wird ein Kern durch mechanisches Recken der martensitischen Phase einer Formgedächtnislegierung gelöst, wobei aufgrund der durch das Recken erzielten Durchmesserverringerung der Kern herausgezogen werden kann. Ein Rohr kann demnach durch Zusammenstecken eines Kerns und eines Mantels oder durch Umschmelzen eines Kerns erzeugt werden.

Die nach dem Stand der Technik bekannten Verfahren sind jedoch nicht geeignet, Hohlformen mit kleinen Abmessungen oder Hohlformen in Form von Endlosprodukten herzustellen.

Der Erfindung liegt unter Berücksichtigung dieses Standes der Technik die Aufgabe zugrunde, ein Verfahren zum Herstellen einer Hohlform zu schaffen, mit dem eine endkonturnahe Herstellung von Präzisionsbauteilen und Präzisionsrohren in nur wenigen Prozeßschritten mit einer hohen Variabilität bezüglich der werkstofflichen und geometrischen Gestaltung möglich ist. Dabei sollen auch kleine Abmessungen sowie vorzugsweise die Herstellung in einer Endlosproduktion bzw. die Herstellung in Bandform möglich sein.

Diese Aufgabe wird erfindungsgemäß durch ein Verfahren mit den Merkmalen des beigefügten Anspruchs 1 gelöst. Bevorzugte Ausgestaltungen und Weiterbildungen der Erfindung ergeben sich aus den abhängigen Ansprüchen und der nachfolgenden Beschreibung mit zugehörigen Zeichnungen.

Ein erfindungsgemäßes Verfahren zum Herstellen einer Hohlform, insbesondere eines Hohlprofils, mit kleinem Außendurchmesser und/oder kleiner Wandstärke, bei dem in einem ersten Schritt ein massiver Kern mit dem Werkstoff der Hohlform beschichtet wird, wobei ein die Hohlform und den Kern umfassender Verbundblock gebildet wird, und in einem zweiten Schritt der Kern aus der Hohlform herausgelöst wird, weist also die Besonderheit auf, daß als Kern ein Werkstoff verwendet wird, der beim Abkühlen schrumpft, der Kern bei einer Beschichtungstemperatur mit dem Werkstoff beschichtet wird, die höher ist als die Entformungstemperatur, bei der der Kern aus der Hohlform herausgelöst wird, und der Kern durch ein Abscheideverfahren mit dem Werkstoff der Hohlform beschichtet wird.

Das Beschichten kann im erfindungsgemäßen Zusammenhang mit jedem bekannten und geeigneten Beschichtungsverfahren, insbesondere Dünnschichtbeschichtungsverfahren erfolgen. Eine erste bevorzugte Ausführungsform ist das Beschichten bzw. Abscheiden mit einem PVD- oder CVD-Verfahren wie Sputtern und Aufdampfen. Besonders bevorzugt ist das galvanische Abscheiden mittels eines elektrochemischen galvanischen Verfahrens, bei dem das Beschichten galvanisch durch elektrolytisches Abscheiden erfolgt. Bei der elektrolytischen Metallabscheidung erfolgt das Abscheiden eines Metalls aus seiner wäßrigen Salzlösung mit Hilfe des elektrischen Stroms.

Eine weitere vorteilhafte Ausführungsform ist das chemische Beschichten, das auch als reduktives Metallabscheiden bezeichnet wird. Eine andere vorteilhafte Ausführungsform ist das Abscheiden durch Umschmelzen des Kerns mit dem Werkstoff der Hohlform.

Die vorstehend genannten Beschichtungs- und Abscheideverfahren sind besonders zur Integration in ein Herstellungsverfahren geeignet, bei dem das Abscheiden des Werkstoffs auf den Kern im Durchlaufverfahren erfolgt, also mit einem Endloskern oder einem Kern mit sehr großer Länge, insbesondere einem Kern in Bandform, der eine Beschichtungs- oder Abscheideanlage bandförmig durchläuft. Bevorzugt wird mit dem erfindungsgemäßen Verfahren die Hohlform im Durchlaufverfahren endlos hergestellt. Eine solche endlose Fertigung kann beispielsweise mit geeigneten Umlenkungen zum Ab- und Aufhaspeln erfolgen.

Nach dem Beschichten des Kerns mit dem die gewünschte Hohlform bildenden Mäntel kann der Kern zum Entformen, d.h. zum Herauslösen des Kerns aus dem gebildeten Verbund aus Mantel und Kern, in einzelne Abschnitte zerteilt werden.

Bevorzugt wird das erfindungsgemäße Verfahren derart gestaltet, daß der Kern durch das Abkühlen von der Beschichtungstemperatur auf die Entformungstemperatur derart mehr als die Hohlform seinen Durchmesser reduziert, daß er im wesentlichen ohne Recken durch Ziehen aus der Hohlform herausgelöst werden kann. In der Praxis wird es sich allerdings nicht ganz vermeiden lassen, daß aufgrund verbleibender Reibungskräfte der Kern in geringem Maße beim Ziehen gereckt wird. Aus diesem Grund ist es vorteilhaft, wenn ein Kernmaterial verwendet wird, das eine hohe Gleichmaßdehnung aufweist.

Zum Erleichtern des Entformens kann vorgesehen sein, daß zwischen dem Kern und der Hohlform eine das Herauslösen erleichternde Gleit- oder Hartstoffschicht aufgebracht wird. Diese Schicht wird vor dem Abscheiden des Mantels auf den Kern aufgebracht.

Besonders vorteilhaft sind Kerne, die aus einer Formgedächtnislegierung bestehen. Shape-Memory- oder Formgedächtnislegierungen zeigen aufgrund einer thermoelastischen martensitischen Umwandlung nach geeigneter Behandlung eine temperaturabhängige Gestaltsänderung. Bei einer thermoelastischen martensitischen Umwandlung entstehen und wachsen die Martensitplatten kontinuierlich mit sinkender Temperatur und sie verschwinden in umgekehrter Weise bei Temperaturerhöhung.

Beispielsweise bei Legierungen, die annähernd gleich viele Titan- und Nickelatome enthalten, sind besondere Effekte zu beobachten, aufgrund derer solche Legierungen auch Formgedächtnislegierungen genannt werden. Die Effekte beruhen auf einer thermoelastischen martensitischen Phasenumwandlung, d.h. einer temperaturabhängigen Änderung der Kristallstruktur: bei hohen Temperaturen ist die Legierung austenitisch, bei niedrigen Temperaturen dagegen martensitisch. Nach T. W. Duerig und H. R. Pelton, ("TI-NI Shape Memory Alloys", in: Materials Properties Handbook: Titanium Alloys, 1994, S. 1035-1048, ASM International 1994) sind bei Formgedächtnislegierungen zwei Eigenschaften zu unterscheiden. Legierungen mit einem Titangehalt zwischen 49,7 bis 50,7 Atom% zeigen ein thermisches Formgedächtnis, auch Shape-Memory genannt, Legierungen mit einem Titangehalt von 49,0 bis 49,4 Atom% ein mechanisches Formgedächtnis, auch Superelastizität genannt. Nicht nur binäre Nickel-Titan-Legierungen können die genannten Eigenschaften haben. Eine Formgedächtnislegierung kann ternäre Bestandteile (z.B. Eisen, Chrom oder Aluminium) enthalten. Das Verhältnis von Nickel und Titan sowie die Anwesenheit ternärer Beimengungen haben großen Einfluß auf die Ausprägung des thermischen und mechanischen Formgedächtnisses.

Um für Bauelemente das thermische Formgedächtnis zu nutzen, wird eine Legierung mit geeigneter Zusammensetzung durch Abkühlen diffusionslos vom austenitischen Gefüge in das martensitische Gefüge umgewandelt. Eine anschließende Verformung eines aus dieser Legierung gefertigten Bauteiles kann durch eine thermische Behandlung des Bauelementes (Erwärmen auf Temperaturen oberhalb einer bestimmten Umwandlungstemperatur) wieder rückgängig gemacht werden. Dabei wird das ursprüngliche austenitische Gefüge wieder eingestellt, und das Bauteil nimmt seine ursprüngliche Gestalt an. Als Umwandlungstemperatur wird im allgemeinen die Temperatur bezeichnet, bei der der Martensit vollständig in Austenit umgewandelt ist. Die Umwandlungstemperatur ist stark von der Zusammensetzung der Legierung und in dem Bauteil herrschenden Spannungen abhängig. Bauelemente, die ein thermisches Formgedächtnis zeigen, können Bewegungen erzeugen und/oder Kräfte ausüben.

Der mechanische Formgedächtniseffekt tritt bei einem Bauelement aus einer geeigneten Legierung mit austenitischem Gefüge ein, wenn das Bauelement in einem bestimmten Temperaturbereich verformt wird. Dabei ist es für das austenitische Gefüge energetisch günstiger, sich spannungsinduziert in Martensit umzuwandeln, wobei elastische Dehnungen von bis zu zehn Prozent erreicht werden können. Bei Entlastung kehrt das Gefüge wieder in die austenitische Phase zurück. Bauelemente aus einer derartigen Legierung werden daher zum Speichern von Deformationsenergie verwendet.

Legierungen, die die oben beschriebenen Eigenschaften zeigen, sind unter den Begriffen Nickel-Titan, Titan-Nickel, Tee-nee, Memorite^{R}, Nitinol, Tinel^{R}_{,} Flexon^{R}, Euroflex^{R} und Shape-Memory-Alloys bekannt. Dabei beziehen sich diese Begriffe nicht auf eine einzelne Legierung mit einer bestimmten Zusammensetzung, sondern auf eine Familie von Legierungen, die die beschriebenen Eigenschaften zeigen.

Für weitere Eigenschaften von Formgedächtnislegierungen, ihre Herstellung und die verschiedenen Varianten wird auf die oben genannte Literaturstelle sowie die folgenden Literaturstellen bezug genommen: Engineering Aspects of Shape Memory Alloys, T. W. Duerig, K. N. Melton, D. Stöckel, C. M. Wayman, Verlag Butterworh-Heinemann Ltd., 1990 und D. Stöckel, Legierungen mit Formgedächtnis, Kontakt & Studium, Band 259, Expert Verlag 1988.

Nach einem bevorzugten Merkmal wird vorgeschlagen, daß die Formgedächtnislegierung eine Ni-Ti-, Cu-Zn-Al- oder Cu-Al-Ni-Legierung ist. Insbesondere der Formgedächtniswerkstoff Nickel-Titan ist bevorzugt, weil er aufgrund seiner natürlichen Oberflächenoxidschicht eine geringe Neigung zu einer Verbindungsbildung mit dem abgeschiedenen Werkstoff hat, so daß das Entformen erleichtert wird. Ferner hat Nickel-Titan, wie allgemein Formgedächtnislegierungen, den Vorteil eines ausgeprägten Spannungsplateaus.

Bei Formgedächtnislegierungen kann das Entfernen des Kerns durch Entformung des Kern im martensitischen Zustand erfolgen oder durch Ausnutzung des Zweiwegeffekts. Allgemein wird im erfindungsgemäßen Zusammenhang nach zusätzlichen vorteilhaften Merkmalen vorgeschlagen, daß die Formgedächtnislegierung eine Formgedächtnislegierung mit Einwegeffekt, mit Zweiwegeffekt oder eine Formgedächtnislegierung mit Allroundeffekt ist oder daß sich beim Herauslösen des Kern aus der Hohlform das Gefüge des Kerns ändert. Weitere vorteilhafte Merkmale können darin bestehen, daß die Beschichtungstemperatur oberhalb der austenitischen Endtemperatur A_{f} der Formgedächtnislegierung liegt. Ferner wird nach einem weiteren vorteilhaften Merkmal vorgeschlagen, daß die Entformungstemperatur unterhalb der martensitischen Endtemperatur M_{f} der Formgedächtnislegierung liegt.

Eine andere vorteilhafte Ausführungsform kann darin bestehen, daß die Hohlform in mehreren verschiedenen Schichten auf den Kern aufgebracht wird. Beispielsweise können Verbundschichten durch Mehrfachabscheidung unterschiedlicher Werkstoffe aufgebracht werden. Auf diese Weise können unter anderem licht- bzw. röntenoptische Markierungen im Wege einer Selektivabscheidung, beispielsweise mit Maskentechniken, erzeugt werden. Nach einem anderen vorteilhaften Merkmal wird vorgeschlagen, daß die auf den Kern aufgebrachte Schicht zwei- und/oder dreidimensional strukturiert wird, beispielsweise um Markierungen oder Durchbrüche zu erzeugen, die auch periodisch angeordnet sein können.

Nach einem weiteren vorteilhaften Merkmal wird vorgeschlagen, daß der Kern einen stufigen und/oder sich kontinuierlich ändernden Querschnitt besitzt, so daß es möglich ist, Hohlformen mit unterschiedlichen Innendurchmessern und/oder Innenkonen herzustellen.

Mit dem erfindungsgemäßen Verfahren können hohle Präzisionsbauteile in nur wenigen Prozeßschritten in einer hohen Variabilität bezüglich der werkstofflichen und geometrischen Gestaltung auch mit sehr kleinen Abmessungen hergestellt werden. Es sind keine aufwendigen Umformwerkzeuge erforderlich und die Herstellung erfordert nur ein Minimum an Verfahrensschritten. Desweiteren kann die Herstellung in Endlosform kostengünstig erfolgen und das Verfahren ermöglicht die Herstellung von Präzisionsbauteilen geringer Abmessungen mit einer hohen geometrischen Abbildungengenauigkeit sowie Gleichwandigkeit. Aufgrund geringer Rüstkosten ist auch die Herstellung von kleinen Mengen wirtschaftlich möglich.

Das erfindungsgemäße Verfahren eignet sich zum Herstellen beliebiger Hohlformen oder Hohlprofile. Eine besonders vorteilhafte Anwendung besteht in der Herstellung von Rohren, die je nach Form des Kerns einen beliebigen Querschnitt aufweisen können. Bevorzugt ist die Herstellung von Rohren mit rundem Querschnitt. Die Erfindung bietet jedoch die Möglichkeit zur Herstellung von beliebigen Hohlprofilen durch Verwendung eines beliebig profilierten Kerns.

Die Erfindung wird nachfolgend anhand eines in den Figuren dargestellten Ausführungsbeispiels näher erläutert. Die darin beschriebenen Besonderheiten können einzeln oder in Kombination miteinander eingesetzt werden, um bevorzugte Ausgestaltungen der Erfindung zu schaffen. Es zeigen:
- Fig. 1: eine Temperatur-Weg-Kennlinie einer Formgedächtnislegierung,
- Fig. 2.: einen Kern aus einer Formgedächtnislegierung bei einer Temperatur oberhalb der Temperatur A_{f},
- Fig. 3: den Kern von Fig. 2 unterhalb der Temperatur M_{f},
- Fig. 4: den Kern von Fig. 2 mit einer Beschichtung,
- Fig. 5: den Verbundblock von Fig. 4 bei einer Temperatur zwischen M_{f} und A_{f},
- Fig. 6: den Verbundblock von Fig. 4 bei einer Temperatur kleiner M_{f} und
- Fig. 7: das Entformen des Verbundblocks von Fig. 6.

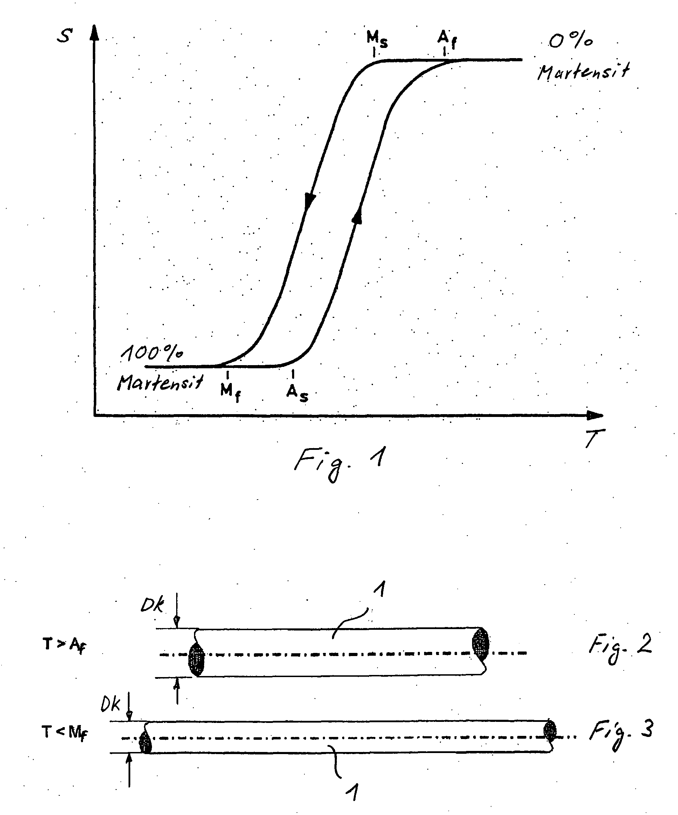

Die Fig. 1 zeigt eine typische Kennlinie des Weges s (bzw. der Verformung oder der Länge) einer Formgedächtnislegierung als Funktion der Temperatur T. Aₛ ist die austenitische Starttemperatur, die Temperatur, bei der die Formänderung beim Erwärmen beginnt. A_{f} ist die austenitische Endtemperatur, die Temperatur, bei der die Formänderung beim Erwärmen beendet ist. Entsprechend bezeichnen Mₛ und M_{f} die martensitische Start- und Endtemperatur, die Temperaturen, bei denen die Formänderung beim Abkühlen beginnt bzw. beendet ist. Die Martensitanteile der Formgedächtnislegierung sind in dem Diagramm auch angegeben.

Die Fig. 2 zeigt einen Kern 1 in Form eines langgestreckten Drahtes mit rundem Querschnitt aus einer Formgedächtnislegierung bei einer Temperatur oberhalb von A_{f}. In Fig. 3 ist derselbe Kern 1 bei einer Temperatur unterhalb von M_{f} dargestellt. Man erkennt, daß sein Durchmesser Dk beim Abkühlen geschrumpft ist. Dieser Schrumpfeffekt ist bei Formgedächtnislegierungen besonders groß. Die Formänderung ist erheblich größer als die mit der thermischen Ausdehnung verbundene Formänderung üblicher Werkstoffe ohne Formgedächtnis.

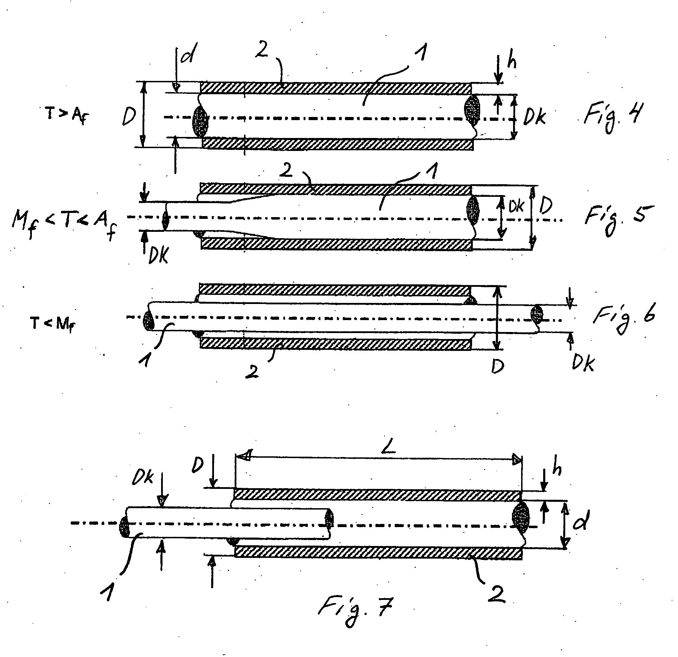

In Fig. 4 ist der mit einer Hohlform 2 beschichtete Kern 1 dargestellt. Bei der Hohlform 2 handelt es sich um ein Rohr mit einem runden Querschnitt. Das Beschichten des Kerns 1 mit dem Material der Hohlform 2 erfolgt in dem in Fig. 4 dargestellten Ausführungsbeispiel bei einer Beschichtungstemperatur größer A_{f} mit einem geeigneten Abscheideverfahren, beispielsweise durch Aufdampfen oder durch galvanisches Abscheiden. Dies kann auch in einem Durchlaufverfahren erfolgen.

Bei dem Werkstoff der Hohlform 2 kann es sich im Prinzip um jeden gewünschten Werkstoff handeln. In manchen Ausführungsformen wird es bevorzugt sein, wenn der Werkstoff der Hohlform 2 ein metallischer Werkstoff ist oder einen metallischen Werkstoff umfaßt. Der Werkstoff kann auch in mehreren, ggf. unterschiedlichen Schichten auf dem Kern 1 abgeschieden werden und erforderlichenfalls durch geeignete Beschichtungs- und Strukturierungsmaßnahmen in einer gewünschten Weise zwei- oder dreidimensional strukturiert werden.

Der Kern 1 weist, unter Berücksichtigung einer evtl. Maßkorrektur aufgrund des späteren Abkühlens der Hohlform 2, die für die Hohlform 2 gewünschte Form der Querschnittsfläche sowie des Durchmessers Dk auf. Beim Beschichten des Kerns 1 entspricht der Durchmesser Dk des Kerns 1 dem Innendurchmesser d der Hohlform 2. Durch Abscheiden des Werkstoffs der Hohlform 2 auf dem Kern 1 in der gewünschten Wandstärke h ergibt sich der Außendurchmesser D der Hohlform 2.

Die Fig. 5 zeigt den aus Kern 1 und Hohlform 2 gebildeten Verbundblock der Fig. 4 während des Abkühlens, und in Fig. 6 ist der nach dem Abkühlen erreichte Zustand bei der Entformungstemperatur dargestellt. Der Kern 1 ist erheblich mehr geschrumpft als die Hohlform 2, so daß der Kern 1 im wesentlichen ohne Recken durch Ziehen aus der Hohlform 2 herausgelöst werden kann. Dieses Entformen ist in Fig. 7 veranschaulicht. Die beschichtete Länge L des Kerns 1 kann vorteilhafterweise zwischen 0,5 mm und 500 m betragen.

Nach einem vorteilhaften zusätzlichen Merkmal kann vorgesehen sein, daß der beschichtete Kern 1 vor dem Entformen in Abschnitte geteilt wird, um das Herauslösen des Kerns 1 zu erleichtern. Die Länge dieser Abschnitte kann bereits auf das Endmaß der gewünschten Halbzeuge oder Endprodukte abgestimmt sein und zwischen wenigen Millimetern und mehreren Metern betragen. Das Unterteilen des Verbundblocks in Abschnitte für das Entformen kann in jeder der in den Figuren 4 bis 7 dargestellten Phasen erfolgen, d.h. bei einer beliebigen Temperatur.

Das in Fig. 7 veranschaulichte Entformen kann etwa bei der Gebrauchstemperatur der Hohlform 2 erfolgen, d.h. bei der Temperatur, bei der die Hohlform 2 später verwendet werden soll. Dies kann die Raumtemperatur oder je nach Anwendungsfall auch eine höhere oder niedrigere Temperatur als Raumtemperatur sein. Nach anderen vorteilhaften Merkmalen kann aber auch vorgesehen sein, daß die Entformungstemperatur oberhalb oder unterhalb der Gebrauchstemperatur der Hohlform 2 liegt.

Mit dem erfindungsgemäßen Verfahren können Hohlformen 2 hergestellt werden, bei denen der Innendurchmesser d und/oder der Außendurchmesser D zwischen 0,01 mm und 30 mm, vorzugsweise zwischen 0,05 mm und 5 mm beträgt. Die Wandstärke h der Hohlform 2 beträgt vorteilhafterweise zwischen 0,1 µm und 5 mm. Das erfindungsgemäße Verfahren ist insbesondere zur Herstellung sehr dünner Hohlformen geeignet.

### Bezugszeichenliste

- 1: Kern
- 2: Hohlform
- Dk: Durchmesser zu 1
- D: Außendurchmesser zu 2
- d: Innendurchmesser zu 2
- h: Wandstärke zu 2
- L: Länge
- s: Weg
- T: Temperatur
- Aₛ: austenitische Starttemperatur
- A_{f}: austenitische Endtemperatur
- Mₛ: martensitische Starttemperatur
- M_{f}: martensitische Endtemperatur

## Patentansprüche

1. Verfahren zum Herstellen einer Hohlform (2), insbesondere eines Hohlprofils, mit kleinem Außendurchmesser (D) und/oder kleiner Wandstärke (h), bei dem in einem ersten Schritt ein massiver Kern (1) mit dem Werkstoff der Hohlform (2) beschichtet wird, wobei ein die Hohlform (2) und den Kern (1) umfassender Verbundblock gebildet wird, und in einem zweiten Schritt der Kern (1) aus der Hohlform (2) herausgelöst wird,
**dadurch gekennzeichnet, daß**
als Kern (1) ein Werkstoff verwendet wird, der beim Abkühlen schrumpft,
der Kern (1) bei einer Beschichtungstemperatur mit dem Werkstoff beschichtet wird, die höher ist als die Entformungstemperatur, bei der der Kern (1) aus der Hohlform (2) herausgelöst wird, und
der Kern (1) durch ein Abscheideverfahren mit dem Werkstoff der Hohlform (2) beschichtet wird.

2. Verfahren nach Anspruch 1, **dadurch gekennzeichnet, daß** das Abscheiden mit einem PVD- oder CVD-Verfahren erfolgt.

3. Verfahren nach einem der vorhergehenden Ansprüche, **dadurch gekennzeichnet, daß** das Abscheiden galvanisch durch elektrolytisches Abscheiden erfolgt.

4. Verfahren nach einem der vorhergehenden Ansprüche, **dadurch gekennzeichnet, daß** das Abscheiden durch eine chemische Beschichtung mit reduktiver Metallabscheidung erfolgt.

5. Verfahren nach einem der vorhergehenden Ansprüche, **dadurch gekennzeichnet, daß** das Abscheiden durch Umschmelzen des Kerns (1) mit dem Werkstoff der Hohlform (2) erfolgt.

6. Verfahren nach einem der vorhergehenden Ansprüche, **dadurch gekennzeichnet, daß** das Abscheiden im Durchlaufverfahren mit einem Endloskern oder einem Kern (1) mit sehr großer Länge (L), insbesondere einem Kern (1) in Profilform erfolgt.

7. Verfahren nach Anspruch 6, **dadurch gekennzeichnet, daß** die Hohlform (2) im Durchlaufverfahren endlos hergestellt wird.

8. Verfahren nach Anspruch 6 oder 7, **dadurch gekennzeichnet, daß** das der beschichtete Kern (1) zum Entformen in Abschnitte zerteilt wird.

9. Verfahren nach einem der vorhergehenden Ansprüche, **dadurch gekennzeichnet, daß** der Kern (1) durch das Abkühlen von der Beschichtungstemperatur auf die Entformungstemperatur derart mehr als die Hohlform (2) seinen Durchmesser reduziert, daß er im wesentlichen ohne Recken durch Ziehen aus der Hohlförm (1) herausgelöst werden kann.

10. Verfahren nach einem der vorhergehenden Ansprüche, **dadurch gekennzeichnet, daß** zwischen dem Kern (1) und der Hohlform (2) eine das Herauslösen erleichternde Gleit- oder Hartstoffschicht aufgebracht wird.

11. Verfahren nach einem der vorhergehenden Ansprüche, **dadurch gekennzeichnet, daß** die Entformungstemperatur etwa bei der Gebrauchstemperatur der Hohlform (2) liegt.

12. Verfahren nach einem der vorhergehenden Ansprüche, **dadurch gekennzeichnet, daß** die Entformungstemperatur oberhalb der Gebrauchstemperatur der Hohlform (2) liegt.

13. Verfahren nach einem der vorhergehenden Ansprüche, **dadurch gekennzeichnet, daß** die Entformungstemperatur unterhalb der Gebrauchstemperatur der Hohlform liegt.

14. Verfahren nach einem der vorhergehenden Ansprüche, **dadurch gekennzeichnet, daß** der Werkstoff der Hohlform (2) ein metallischer Werkstoff ist oder einen metallischen Werkstoff umfaßt.

15. Verfahren nach einem der vorhergehenden Ansprüche, **dadurch gekennzeichnet, daß** die Hohlform (2) in mehreren verschiedenen Schichten auf den Kern (1) aufgebracht wird.

16. Verfahren nach einem der vorhergehenden Ansprüche, **dadurch gekennzeichnet, daß** die auf den Kern (1) aufgebrachte Schicht zwei- und/oder dreidimensional strukturiert wird.

17. Verfahren nach einem der vorhergehenden Ansprüche, **dadurch gekennzeichnet, daß** der Kern (1) einen sich stufig und/oder kontinuierlich ändernden Querschnitt hat.

18. Verfahren nach einem der vorhergehenden Ansprüche, **dadurch gekennzeichnet, daß** der Kern (1) ein beliebig geformtes Profil besitzt.

19. Verfahren nach einem der vorhergehenden Ansprüche, **dadurch gekennzeichnet, daß** der Kern (1) aus einer Formgedächtnislegierung besteht.

20. Verfahren nach Anspruch 19, **dadurch gekennzeichnet, daß** die Formgedächtnislegierung eine NiTi-, Cu-Zn-Aloder Cu-Al-Ni-Legierung ist.

21. Verfahren nach Anspruch 19, **dadurch gekennzeichnet, daß** die Forgedächtnislegierung eine Formgedächtnislegierung mit Einwegeffekt ist.

22. Verfahren nach Anspruch 19, **dadurch gekennzeichnet, daß** die Forgedächtnislegierung eine Formgedächtnislegierung mit Zweiwegeffekt ist.

23. Verfahren nach Anspruch 19, **dadurch gekennzeichnet, daß** die Forgedächtnislegierung eine Formgedächtnislegierung mit Allroundeffekt ist.

24. Verfahren nach Anspruch 19, **dadurch gekennzeichnet, daß** die Beschichtungstemperatur oberhalb der austenitischen Endtemperatur A_{f} der Formgedächtnislegierung liegt.

25. Verfahren nach Anspruch 19, **dadurch gekennzeichnet, daß** die Entformungstemperatur unterhalb der martensitischen Endtemperatur M_{f} der Formgedächtnislegierung liegt.

26. Verfahren nach Anspruch 19, **dadurch gekennzeichnet, daß** sich beim Herauslösen des Kerns (1) aus der Hohlform (2) das Gefüge des Kerns (1) ändert.

27. Verfahren nach einem der vorhergehenden Ansprüche, **dadurch gekennzeichnet, daß** die Hohlform (2) ein Rohr, vorzugsweise ein Rohr mit rundem Querschnitt ist.

28. Verfahren nach einem der vorhergehenden Ansprüche, **dadurch gekennzeichnet, daß** der Innendurchmesser (d) und/oder der Außendurchmesser (D) der Hohlform (2) zwischen 0,01 mm und 30 mm, vorzugsweise zwischen 0,05 mm und 5 mm beträgt.

29. Verfahren nach einem der vorhergehenden Ansprüche, **dadurch gekennzeichnet, daß** die Wandstärke (h) der Hohlform (2) zwischen 0,1 um und 5 mm beträgt.

30. Verfahren nach einem der vorhergehenden Ansprüche, **dadurch gekennzeichnet, daß** die Länge (L) der Hohlform (2) beim Beschichten zwischen 0,5 mm und 500 m beträgt.

31. Verfahren nach einem der vorhergehenden Ansprüche, **dadurch gekennzeichnet, daß** der beschichtete Kern (1) vor dem Entformen in Abschnitte geteilt wird.

32. Hohlform (2), insbesondere Hohlprofil, **dadurch gekennzeichnet, daß** es nach einem Verfahren nach einem der Ansprüche 1 bis 31 hergestellt ist.
